# EUROPEAN PATENT SPECIFICATION

(11) **EP 2 457 238 B1**
(45) Date of publication and mention of the grant of the patent: **11.06.2014**
(21) Application number: 10737773.1
(22) Date of filing: 19.07.2010
(51) Int. Cl.: H01B 1/24, H01L 31/0224

(54) **A CONDUCTIVE LAYER FOR USE IN A PHOTOVOLTAIC DEVICE OR OTHER ELECTRONIC APPLICATION**
LEITSCHICHT ZUR VERWENDUNG IN FOTOVOLTAIKVORRICHTUNGEN ODER ANDEREN ELEKTRONISCHEN ANWENDUNGEN
COUCHE CONDUCTRICE À UTILISER DANS UN DISPOSITIF PHOTOVOLTAÏQUE OU AUTRE APPLICATION ÉLECTRONIQUE

(30) Priority: 23.07.2009 EP 09009583; 23.09.2009 EP 09012078
(43) Date of publication of application: 30.05.2012
(73) Proprietor: Swansea University, Swansea SA2 8PP (GB)
(72) Inventor: BÖHM, Siva, NL-1970 CA Ijmuiden (NL); ENGLISH, Timothy, NL-1970 CA Ijmuiden (NL); HAMMOND, Deborah, NL-1970 CA Ijmuiden (NL)
(74) Representative: Ratcliffe, Susan Margaret
(86) International application number: PCT/EP2010/004382
(87) International publication number: WO 2011/009574

(56) References cited:
- EP-A2- 1 605 479
- WO-A2-2006/132766
- US-A- 5 111 178
- US-A1- 2007 125 418
- US-B1- 6 863 923
- DATABASE WPI Week 200948 Thomson Scientific, London, GB; AN 2009-K29455 XP002563921 & CN 101 447 341 A (UNIV NANJING AERONAUTICS&ASTRONAUTICS) 3 June 2009 (2009-06-03)

## Description

The invention relates to a conductive layer for use in a photovoltaic (PV) device or other electronic application such as large area lighting and displays and a method of manufacturing the same. The invention further relates to a dye sensitised solar cell comprising said conductive layer.

Photovoltaic devices are based on the concept of charge separation at an interface of light absorbing and semiconducting materials. To date this field has been dominated by solid-state p-n type junction devices typically made of silicon. However, this field is now being challenged by a 3^{rd} generation of photovoltaic devices based on nanocrystalline and conducting polymer films. Dye sensitised solar cells fall into this category and are characterised by their low cost and ease of manufacture.

Dye sensitised solar cells (DSSCs) as first developed by Dr Michael Gratzel and co-workers comprise a working electrode and a counter electrode, which when sealed encapsulate an electrolyte. The working electrode comprised a conductive layer of fluorine doped tin oxide (SnO₂:F) deposited onto the back of a glass substrate and a PV absorber layer on the layer of SnO₂:F, the PV absorber layer being composed of sintered metal oxide nanometer-sized particles that are sensitised with a light absorbing dye. The counter electrode also made use of a conductive SnO₂:F coated glass substrate onto which a layer of platinum catalyst was deposited.

A sintered metal oxide is required to achieve sufficient interconnectivity between nanoparticles and increase adhesion between the nanoparticles and the conductive SnO₂:F coated substrate. Despite the low fabrication costs associated with the dye sensitised solar cells based on Gratzel's design, sintering the metal oxide limits DSSC fabrication to a batch process, which cannot be easily modified into a continuous process since rigid transparent materials such as glass are required as substrates.

A number of factors contribute to the overall performance of a dye sensitised solar cell. For example, the nature of the light absorbing dye will determine which regions of the electromagnetic spectrum the dye will absorb and also how efficient the dye can transfer electrons into the conduction band of the metal oxide. The surface area of the metal oxide and the interconnectivity of the nanoparticles thereof are also important considerations when optimising DSSC efficiency.

The electrical sheet resistance of the conductive layer in the working electrode and the counter electrode is also an important factor since this will determine the extent of the resistive losses and overall conductivity of these layers. With respect to the working electrode the integrity of the conductive layer should also be maintained even after the step of sintering the metal oxide.

Metal foils such as titanium have been used as conductive layers in the past since titanium is able to withstand the high temperatures associated with sintering the metal oxide. Moreover, titanium has a low sheet resistance and is resistant to corrosion by the electrolyte. However, foils such as titanium are prohibitively expensive and difficult to handle, thus restricting industrialisation of dye sensitised solar cells comprising such foils.

It is an object of this invention to provide a conductive layer for use in a dye sensitised solar cell, photovoltaic device or other electronic application.

It is an object of this invention to provide a conductive layer for use in a dye sensitised solar cell, photovoltaic device or other electronic application having a low electrical sheet resistivity.

It is an object of this invention to provide a conductive layer for use in a dye sensitised solar cell, photovoltaic device or other electronic application that will not degrade upon exposure to high temperatures.

It is an object of this invention to provide a conductive layer for use in a dye sensitised solar cell, photovoltaic device or other electronic application that can be implemented into a continuous roll to roll production line.

It is an object of this invention that the conductive layer is applied to the substrate by conventional coating methods such as screen printing or roller coating and that the conductivity of the layer is developed during the drying and curing of the originally applied wet film.

It is an object of this invention to provide a conductive layer for use in a dye sensitised solar cell, photovoltaic device or other electronic application that is a low cost alternative to conductive layers based on metal foils.

According to a first aspect of this invention at least one of the objects is reached by providing a conductive layer for use in a photovoltaic device or other electronic application, which comprises carbon nanotubes as a conductive material, carbon black and/or graphite as a conductive additive and a temperature resistant polymeric material, wherein the polymeric material is resistant to temperatures in the range of 200 to 600°C and the conductive layer has an electrical sheet resistance of less than 100 Ohm/square. The inventors found that the conductive layer comprising a mixture of the conductive material and the polymeric material alone generated a conductive layer sheet resistance in the range of 200 to 300 Ohm/square as measured with a two point probe. The addition of a first conductive additive reduced the resistance of the conductive layer to values between 100 Ohm/square and 15 Ohm/square. The term temperature resistant means that the resulting conductive layer is able to withstand the temperatures used in subsequent manufacturing steps for the duration of such steps with typical temperatures being in the range of 200°C to 600°C. The integrity of an underlying polymeric insulating layer and the conductive layer, which comprises the conductive material, the conductive additive and the polymeric material may be assessed by cyclic voltammetry, which measures current flow per unit area for varying electrode potential, and consequently demonstrates the ability of the conductive layer and polymeric insulating layer to protect a metal carrier substrate from corrosion. An increase in current flow would be indicative of thermal degradation of the conductive layer and/or the polymeric insulating layer. However, results indicated that the integrity of the conductive layer and/or the polymeric insulating layer were largely unaffected after the heat treatment, which comprised subjecting the conductive layer to temperatures of up to 600°C, preferably for a period of 300 seconds or less.

Surprisingly, the conductive layer exhibited a further reduction in sheet resistance after heat treatment, which the inventors believe is due to the polymeric material forming a cross-linked network that reduces the dry thin film thickness of the polymeric material; consequently the interface distance between the conductive material and the first conductive additive is reduced which should further reduce the sheet resistance of the conductive layer.

According to the invention the conductive layer comprises carbon nanotubes due to the unique combination of properties they possess, namely, excellent strength, electrical conduction and temperature resistance (750°C). Thus, carbon nanotubes can withstand high temperature manufacturing processes such as sintering in the case of dye sensitised solar cells. Multi-walled walled carbon nanotubes (MWCNT) or single walled carbon nanotubes (SWCNT) can be used. The conductive layer comprising carbon nanotubes, the polymeric material and the conductive additive exhibits a reduction in electrical sheet resistance since the carbon nanotubes form conductive paths between conductive additive particles, thus reducing the detrimental influence of the insulating polymeric material on conductivity.

According to the invention there is provided a conductive layer wherein the conductive additive comprises graphite and/or carbon black. The presence of the conductive additive within the conductive layer should reduce the electrical sheet resistance of the conductive layer since the conductive additive reduces the detrimental influence of the insulating polymeric coating on conductivity. In general, an increase in the concentration of the conductive additive results in a reduction in electrical sheet resistance. At higher concentrations the interface distance between conductive additives is reduced, which facilitates an increase in the number of conductive paths formed between the conductive material and the conductive additive and consequently the electrical sheet resistance of the conductive layer is reduced. At lower conductive additive concentrations the interface distance between conductive additives is large, resulting in fewer conductive paths being formed and consequently an increase in electrical sheet resistance is observed relative to a conductive layer comprising a higher concentration of the conductive additive. The use of low cost materials such as carbon black and/or graphite may be blended with TiN, TiC, molybdenum, tungsten, titanium or stainless steel, singly or in combination, to further reduce the electrical sheet resistance of the conductive layer, or to maintain the sheet resistance but reduce the viscosity of the liquid coating for easier processing, due a reduction in the total loading of the conductive additive.

In an embodiment of the invention there is provided a conductive layer for a dye sensitised solar cell (DSSC). The conductive layer can be used as a low cost alternative to expensive conducting layers such as titanium metal, which is currently used in DSSCs. The conductive layer also overcomes problems associated with the high temperature sintering steps that are required during DSSC fabrication to increase the surface area of the metal oxide layer and the interconnectivity of metal oxide nanoparticles. Conducting layers such as indium doped tin oxide (ITO) are not compatible with such sintering conditions and will thermally degrade. The conductive layer is also resistant to the electrolyte unlike other conducting layers including stainless steel. The conductive layer can also be provided by roller coating, doctor-blading, spray coating, printing, extrusion or lamination all of which can be implemented into a continuous roll to roll production line.

In an embodiment of the invention there is provided a conducting layer that is a back contact. In the context of a DSSC this is particularly favourable since it permits the manufacture of DSSCs having a reverse design. In this reverse design, the working electrode is carried by a metal carrier substrate; an electrically insulating layer is provided on this metal carrier, and an electrical conductor is provided on top of the insulating layer, which will function as the back contact. As the electrically insulating layer and the first conductive layer do not have to show transparency, unlike the conductive layer of the front counter electrode, there is more freedom for selecting suitable high temperature resistant materials.

In an embodiment of the invention there is provided a conductive layer wherein the electrical sheet resistance of the conductive layer is 30 Ohm/square or less and preferably less than 15 Ohm/square. The conductive layer should preferably have a low electrical sheet resistance so that resistive losses in the conductive layer are minimized. If resistive losses are too great within a conductive layer then bus bars and current collectors will have to be provided to alleviate the problem. The provision of bus bars and current collectors will increase process times and manufacturing costs.

In an embodiment of the invention there is provided a conductive layer wherein the conductive material comprises carbon nanotubes. A conductive layer comprising carbon nanotubes is preferable due to the unique combination of properties they possess, namely, excellent strength, electrical conduction and temperature resistance (750°C). Thus, carbon nanotubes can withstand high temperature manufacturing processes such as sintering in the case of dye sensitised solar cells. Multi-walled walled carbon nanotubes (MWCNT) or single walled carbon nanotubes (SWCNT) can be used. The conductive layer comprising carbon nanotubes, the polymeric material and the conductive additive exhibits a reduction in electrical sheet resistance since the carbon nanotubes form conductive paths between conductive additive particles, thus reducing the detrimental influence of the insulating polymeric material on conductivity.

In an embodiment of the invention there is provided a conductive layer comprising 1% to 10% and preferably 3 to 8%, by dry weight of the conductive material. Conductive layers comprising 4% to 8% and 6% to 8% of the conductive material also reduce the sheet resistivity of the layer. In general conductive layers having higher concentrations of the conductive material i.e., 8% by dry weight, exhibit a lower sheet resistivity, presumably due to the formation of more conductive paths. However, since the conductive material greatly increases coating viscosity it is preferable not to exceed conductive material concentrations of 10% by dry weight to avoid potential processing issues posed by too great a viscosity. Whilst coating viscosity before drying and curing can be reduced by the addition of more solvent, it then becomes a processing issue as to whether a sufficiently thick wet film can be deposited using conventional coating technologies to provide a suitable dry film thickness following the drying and curing steps.

In an embodiment of the invention there is provided a conductive layer wherein the polymeric material is a polyimide or a polysilane or a polysiloxane. The materials used in accordance with the invention are resistant to high temperature processing steps in the range of 200°C to 600°C, resistant to corrosion by the electrolyte, have good adhesion to previously and subsequently applied layers and are compatible with conventional polymer coating processes.

In an embodiment of the invention there is provided a conductive layer comprising 20% to 75%, preferably, 30% to 60%, and more preferably 30% to 50% by dry weight of the polymeric material.

The concentration of the polymeric material in the conductive layer is determined by the concentrations of the conductive material and the conductive additive, which are varied to obtain the best conductivity possible. The purpose of the polymeric material is to resist temperatures in the range of 200°C and 600 °C and disperse the conductive material and conductive additive. Conductive layers with insufficient polymeric material, i.e., 20% or less tend to be too porous and consequently absorb the electrolyte and may crack after the step of sintering the metal oxide. It is therefore necessary to strike a balance between the conductivity of the conductive layer and its performance as a barrier layer. This is typically achieved by providing conductive layers having a polymeric material concentration in the range of 30% to 50% by dry weight and in certain instances 40% to 50% weight %.

In an embodiment of the invention there is provided a conductive layer wherein the conductive additive comprises graphite, carbon black, TiN, TiC, molybdenum, tungsten, titanium, stainless steel or a combination thereof. The presence of the conductive additive within the conductive layer should reduce the electrical sheet resistance of the conductive layer since the conductive additive reduces the detrimental influence of the insulating polymeric coating on conductivity. In general, an increase in the concentration of the conductive additive results in a reduction in electrical sheet resistance. At higher concentrations the interface distance between conductive additives is reduced, which facilitates an increase in the number of conductive paths formed between the conductive material and the conductive additive and consequently the electrical sheet resistance of the conductive layer is reduced. At lower conductive additive concentrations the interface distance between conductive additives is large, resulting in fewer conductive paths being formed and consequently an increase in electrical sheet resistance is observed relative to a conductive layer comprising a higher concentration of the conductive additive. The use of low cost materials such as carbon black and/or graphite is preferred although they may be blended with TiN, TiC, molybdenum, tungsten, titanium or stainless steel, singly or in combination, to further reduce the electrical sheet resistance of the conductive layer, or to maintain the sheet resistance but reduce the viscosity of the liquid coating for easier processing, due a reduction in the total loading of the conductive additive.

In an embodiment of the invention there is provided a conductive layer comprising 20% to 80%, preferably, 30% to 60% and more preferably 40% to 60% by dry weight of the conductive additive. The conductive layer comprising conductive additives in the concentration range of 40% to 60% by dry weight is preferable since the conductive layer has a suitable viscosity for continuous processing. Suitable viscosities are also obtained when conductive layers comprise 40% to 50% by dry weight of the conductive additives. In addition, once the conductive layer is dried and cured conductive paths are formed between the conductive material and the conductive additive, which facilitate the flow of electrical current across the insulating polymer material. In general, at lower conductive additive concentrations, i.e., 30% by dry weight, the interface distance between conductive additives is large, thus fewer conductive paths are formed and the extent of electrical sheet resistance reduction is limited. It is expected that interface distances will become too great if concentrations lower than 30% by dry weight are used; consequently a noticeable reduction in conductive path formation will be observed. In contrast, at higher conductive additive concentrations, i.e., 80% by dry weight and the interface distance between conductive additives is reduced. Thus, more conductive paths become available and the electrical sheet resistance of the conductive layer is expected to reduce. However, it has been shown that at higher conductive additive concentrations, and in instances, above 80 wt%, the coating layer is too porous and crack formation in the conductive layer can occur after the metal oxide layer has been sintered. It is possible to produce conductive layers having good conductivity, i.e., less than 30 Ohms/square with only the polymeric material and the conductive additive., However, without the conductive material, it is difficult to maintain the conductive additive in suspension with the polymeric material, which results in problems with the subsequent processing steps.

In a preferred embodiment of the invention there is provided a conductive layer comprising a second additive such as BYK 341 or BYK ES 80 or siloxanes. BYK is a chemical company which produces polyether modified polydimethylsiloxane in butyl glycol (BYK341) and an alkylammonium salt of an unsaturated acidic carboxylic ester in isobutanol (BYK ES 80). The purpose of BYK ES 80 is to increase the conductivity of the conductive layer by forming an electrically conducting 'skin' around the conductive additive. The purpose of BYK 341 or siloxanes is to increase the wetting of the conductive layer. BYK 341 or siloxanes reduce the surface tension of the conductive layer and therefore surface de-wetting is minimised, which is important when depositing the conductive layer onto a substrate.

According to a second aspect of the invention there is provided a method of producing a conductive layer. This method comprises the steps of:
i. placing carbon nanotubes as a conductive material, carbon black and/or graphite as a conductive additive, optionally a second additive and an organic solvent into a reaction vessel;
ii. mixing the conductive material, the conductive additive, optionally the second additive and the organic solvent together into a homogeneous dispersion;
iii. adding a polymeric material to the homogeneous dispersion to form a mixture;
iv. mixing the mixture and applying the mixture on a substrate;
v. drying and curing the polymeric material.

A dispersion of the conductive material and the conductive additive is obtained after mixing with a high shear mixer. It is preferable to obtain a homogeneous dispersion of the conductive material and the conductive additive so that when the polymeric material is added to the dispersion, the conductive material and conductive additive are distributed evenly throughout the polymeric material. Other techniques that could be used to achieve uniform distribution of conductive components in a polymer material include extrusion, sonication, and in-situ polymerisation. The addition of the second additive has the advantages as discussed above. The mixture is mixed a second time to ensure a uniform conductive layer is obtained, the mixing may be carried out by stirring or by sonication in a sonication bath for example.

In an embodiment of the invention the conductive layer produced according to the second aspect of the invention is provided on a substrate preferably in a continuous reel to reel production line. The conductive layer can be deposited by roller coating, doctor-blading, spray coating, printing, extrusion or lamination, which is preferable since vacuum based sputter and vapour process are not required (batch process). Following deposition, the conductive layer is dried to remove any solvent and subsequently heated to a temperature to enable any curing reactions, for example cross linking, associated with the polymeric material. Advantageously, the conductive layer exhibits a temperature resistance in the range of 200°C to 600°C and is able to withstand the high temperatures associated with sintering the metal oxide in subsequent processing steps. Due to the inherent flexibility of the conductive layer it can also be coiled and uncoiled once it has been deposited onto a substrate, providing the substrate itself is flexible.

The preferred embodiments disclosed hereinabove relating to the first aspect of the invention are similarly applicable to the method according to the second aspect of the invention.

According to a third aspect of the invention there is provided a dye sensitised solar cell comprising a metal carrier substrate, an electrically insulating layer on the metal carrier substrate, the conductive layer according the first aspect of the invention, a photoabsorber layer comprising a dye sensitised metal oxide, a counter electrode on the photoabsorber layer and an encapsulated electrolyte between the photoabsorber layer and the counter electrode.

The use of the metal carrier substrate enables the working electrode to be provided in a continuous reel to reel process due to the inherent flexibility, temperature resistance and strength of the metal carrier substrate. The electrically insulating layer comprises low cost materials that are resistant to the temperatures associated with the step of sintering the metal oxide. This layer may be deposited by printing, roller coating, doctor blading, spray coating, extrusion or lamination. The inherent flexibility of the layer also permits it to be used in a roll to roll process. The conductive layer has the advantages of the first aspect of the invention and any one of its embodiments. The sintered metal oxide deposited on the conductive layer is characterised by a large surface area onto which a high concentration of dye molecules can absorb so that the dye sensitised metal oxide can act as a light sponge. The sintered metal oxide is also characterised by a high concentration of interconnected metal oxide nanoparticles that increase the conductivity of the layer. The electrolyte can be provided in the form of liquid or a gel and is deposited on the dye sensitised metal oxide. Advantageously, the counter electrode comprises a transparent film, a transparent barrier layer, a transparent conductive layer and a layer of catalytic material. The counter electrode is manufactured separately and then provided on the photoabsorber layer so that the transparent film and subsequent layers are not subjected to the high temperature step of sintering the metal oxide, which would lead to thermal degradation of the transparent film.

In an embodiment of the invention there is provided a dye sensitised solar cell comprising a second conductive layer between the insulating layer and the conductive layer. The second conductive layer may comprise single or multiple layers. This layer can have high conductivity without the constraint of needing to be resistant to corrosion by the electrolyte, from which it is protected by the original conducting layer. By providing the second conductive layer it is expected that the overall conductivity of the dual conductivity layer combination will increase.

The invention will now be further explained by the following non-limitative examples and figures.

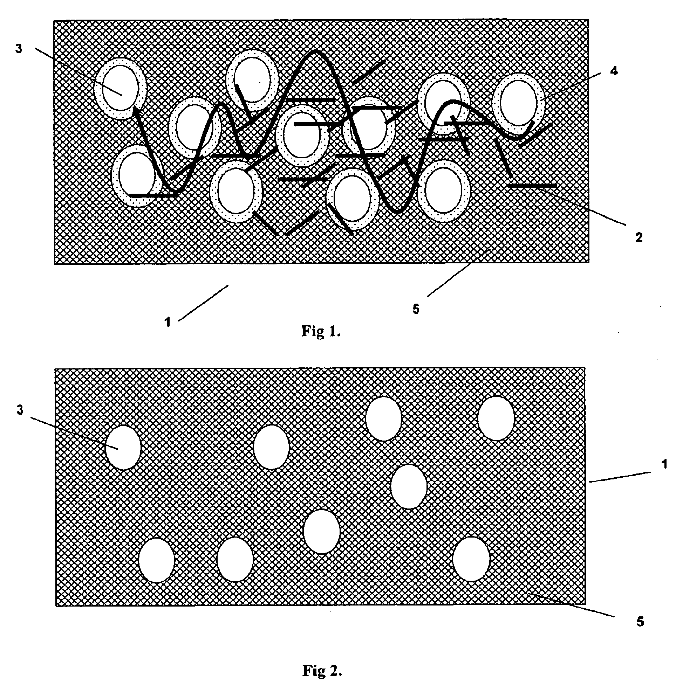

Figure 1 shows a model of the conductive material the conductive additive and the second additive dispersed in the polymeric material with a conductive path (low sheet resistance).
Figure 2 shows a model of the conductive additive dispersed in the polymeric material without a conductive path (high sheet resistance).
Figure 3 shows a temperature/time profile used for drying and curing the conductive layer.
Figure 4 is an example of the sintering cycle that is used when sintering the metal oxide.
Figure 5 shows a cyclic voltammetry trace for a metal carrier with an insulating layer and a conducting layer during a sintering cycle, wherein the temperature reached by the conductive layer during the sintering cycle is 550°C.
Figure 6 shows cyclic voltammetry traces for a temperature resistant polymer before and after a sintering cycle, wherein the temperature reached by the temperature resistant polymer during the sintering cycle is 550°C.
Figure 7 shows a reverse design dye sensitised solar cell comprising the conductive layer.

A conductive layer 1 is prepared in the following way: A conductive material 2 such as carbon nanotubes, a first conductive additive 3 such as graphite or a blend of graphite, carbon black, TiN, TiC, molybdenum, tungsten, titanium or stainless steel and an organic solvent such as N-methyl-1-pyrrolidinone (NMP), which is pre-mixed with a second conductive additive 4 such as BYK ES 80, and/or wetting agents such as BYK 341 or siloxanes, are placed into a reaction vessel and mixed together using a high shear mixer (L5M-SS, Silverson Machines Ltd) to preferably form a homogeneous dispersion. Although preparation of the dispersion is carried out at room temperature, the act of shear mixing at speeds between 4000 and 8000 revolutions per minute generates additional heat. A polymeric material such as polyamic acid in NMP is then added to the dispersion to form a mixture. The mixture is then stirred for a second time until there is no further visual change; the mixture is then preferably subjected to an ultrasonic treatment to ensure that there is uniform dispersion of the carbon nanotubes, graphite and the second conductive additive within polyamic acid.

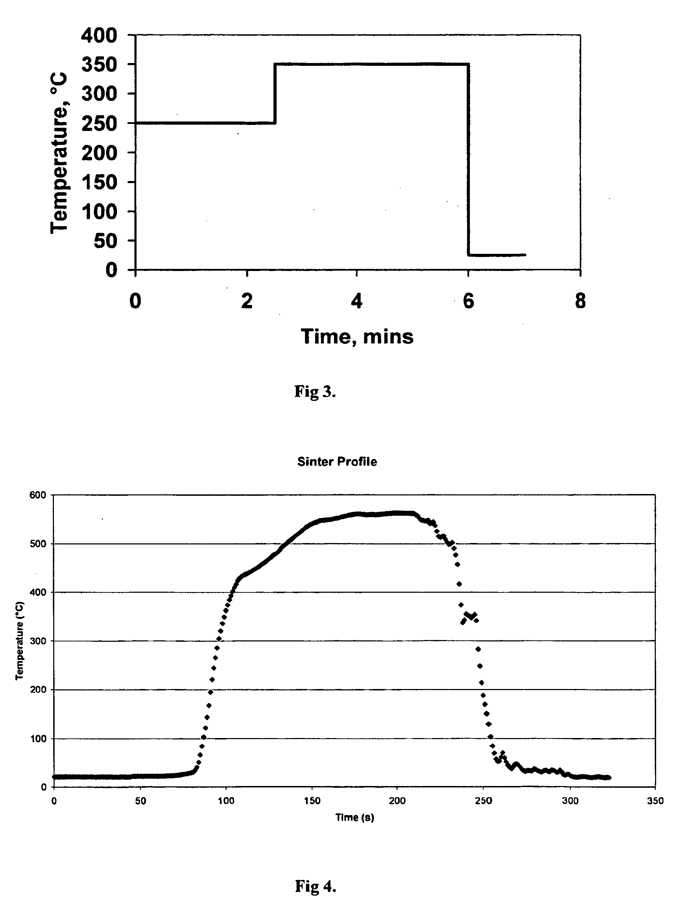

The conductive layer **1** is applied onto a metal carrier substrate which has been coated with a polymeric insulation layer before the conductive layer is dried and cured. During the drying and curing cycle all of the organic solvent (typically NMP) is preferably removed since any residual NMP will increase the sheet resistivity of the conductive layer. NMP has a boiling point of 204.3°C at 760mm Hg. Upon solvent removal and subsequent curing, polyamic acid undergoes a condensation reaction to produce a temperature resistant cross-linked network of polyimide **5**. A typical theoretical drying and curing cycle is shown in Figure 3.

The conductive layer **1** may then be used as a back contact in a dye sensitised solar cell 6 comprising a metal carrier substrate 7, an electrically insulating layer **8** on the metal carrier substrate, the conductive layer on the electrically insulating layer, a photoabsorber layer 9 comprising a dye sensitised metal oxide on the conductive layer, a counter electrode 10 on the photoabsorber layer and an encapsulated electrolyte 11 between the photoabsorber layer and the counter electrode.

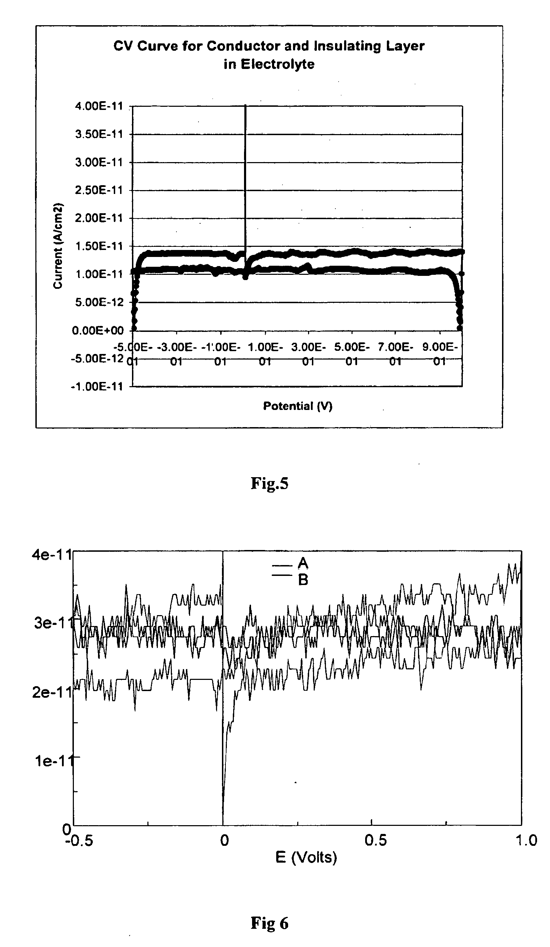

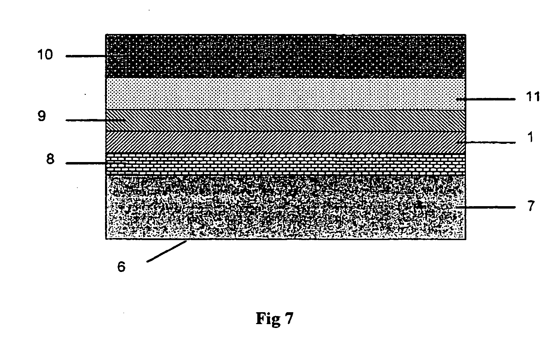

The temperature resistance of the polyimide **5** was determined by performing cyclic voltammetry (CV) experiments before and after subjecting the conductive layer, polymeric insulation layer and metal carrier to a heat treatment of 550°C, which is typical of a sintering operation normally associated with DSSC production. A temperature/time curve for this operation is shown in Figure 4. An electrochemical cell is provided with a metal carrier as the working electrode and a platinum wire as the counter electrode. Figure 5 shows a CV trace measured in an iodine based electrolyte in which the conductive layer is isolated from the metal carrier by a polymer insulating layer and shows a current density of 0.1 nA/cm2 after a simulated sinter. Figure 6 shows CV traces measured in 1 M NaCl solution for the polymeric insulating layer before (A) and after (B) a simulated sinter, with a Ag/AgI reference electrode, and also shows a current density of 0.1 nA/cm2 in both instances. From these results we can conclude that the polymer insulating layer and the conductive layer, both based on polyimide, are suitable materials for the DSSC construction, Figure 7.

The electrical sheet resistivity of the conductive layer can be expressed in 'Ohms per square'; this value gives the resistance in Ohms of current passing from one side of a square region in the conductive layer to the opposite side, regardless of the size of the square. The electrical sheet resistivity was measured by a commercially available resistivity meter that is manufactured by Guardian in Florida, model SRM-232-100. Table 1 shows the electrical sheet resistivity of conductive layers having different compositions. The components of the conductive layer including carbon nanotubes, polyimide, graphite, BYK 341 and BYK ES 80 are expressed in terms of % by weight of the dry conductive layer, i.e., after the conductive layer has been cured. The sheet resistances are measured after the material had been sintered.

Examples 1 to 2 relate to conductive layers wherein polyimide and MWCNT are present alone. Here, electrical sheet resistance can be reduced by increasing the concentration of MWCNT.

Examples 3 to 8 relate to conductive layers wherein MWCNT are not present and show that electrical sheet resistivities can be obtained between 30 and 100 Ohm/square if the coating comprises a high graphite content, i.e., 70 to 80 wt%. However, for conductive layers comprising graphite contents below 70 wt% then electrical sheet resistances in the range of 400 to 3000 Ohm/square are observed.

Examples 8, 9 and 10 show that adding a small % of carbon nanotubes to a high graphite coating, 80%, will decrease the sheet resistance further. This in addition to improving the longevity of the suspension of conductive additives in the polymeric material prior to coating.

Examples 11 and 12, in comparison with example 6, show a reduction in sheet resistance of the conductive layer when carbon nanotubes are used together with approximately 70% graphite, compared to only 70% graphite or only carbon nanotubes - examples 1 and 2.

Examples 13 to 19, in comparison with example 4, show much reduced sheet resistances are obtainable when carbon nanotubes are used with graphite particles compared to the same concentration of graphite particles alone, and that sheet resistance <15 ohms/sq are obtainable.

Examples 20 to 23, in comparison with example 3, show an even greater reduction of the sheet resistance through the action of the carbon nanotubes, but also demonstrate the necessity of sufficient graphite to reach the very low sheet resistances of examples 14 to 19.

**Table 1: The electrical sheet resistivity of conductive layers having different chemical compositions selected from carbon nanotubes, polyimide, graphite, BYK 341 and BYKES 80.**

| Example | MWCNT (%wt) | Graphite (%wt) | Polyimide (wt%) | BYK 341 (wt%) residue | BYK ES 80 (wt%) residue | Thickness (µm) | Resistance (Ω/sq) |
|---|---|---|---|---|---|---|---|
| 1 | 17 | 0 | 83 | 0 | 0 | 20 | 300 |
| 2 | 29 | 0 | 71 | 0 | 0 | 18 | 200 |
| | | | | | | | |
| 3 | 0 | 38 | 62 | 0 | 0 | 32 | Inf |
| 4 | 0 | 50 | 50 | 0 | 0 | 24 | 3000 |
| 5 | 0 | 60 | 40 | 0 | 0 | 38 | 400 |
| 6 | 0 | 70 | 30 | 0 | 0 | 38 | 100 |
| 7 | 0 | 80 | 20 | 0 | 0 | 38 | 30 |
| 8 | 0 | 78.9 | 19.7 | 0.04 | 1.4 | 27 | 26 |
| | | | | | | | |
| 9 | 1 | 78.9 | 18.7 | 0.04 | 1.3 | 42 | 17 |
| 10 | 2 | 79 | 17.8 | 0.04 | 1.3 | 32 | 18 |
| | | | | | | | |
| 11 | 2.8 | 69.1 | 27 | 0.1 | 1.1 | 28 | 17 |
| 12 | 4.9 | 68.8 | 24.6 | 0.05 | 1.6 | 22 | 25 |
| | | | | | | | |
| 13 | 2.7 | 54.3 | 40.7 | 0.1 | 2.2 | 16 | 40 |
| 14 | 4 | 50.3 | 45.3 | 0.03 | 0.4 | 18 | 18 |
| 15 | 5.9 | 49.3 | 44.4 | 0.02 | 0.4 | 17 | 15 |
| 16 | 6.8 | 48.8 | 43.9 | 0.02 | 0.4 | 19 | 14 |
| 17 | 7.7 | 48.3 | 43.5 | 0.02 | 0.4 | 19 | 12 |
| 18 | 8.6 | 47.7 | 42.9 | 0.05 | 0.8 | 12 | 16 |
| 19 | 9.4 | 47.2 | 42.5 | 0.05 | 0.8 | 14 | 22 |
| | | | | | | | |
| 20 | 3.8 | 38.3 | 57.5 | 0.02 | 0.4 | 11 | 100 |
| 21 | 4.5 | 44.7 | 50.3 | 0.03 | 0.4 | 13 | 60 |
| 22 | 6.6 | 43.8 | 49.2 | 0.03 | 0.4 | 11 | 35 |
| 23 | 7.2 | 35.9 | 5.9 | 0.2 | 2.9 | 13 | 80 |

Table 2 gives examples of when graphite and carbon black are used together with carbon nanotubes.

Example 24 shows that a low surface resistivity can be achieved with only carbon black dispersed in polyimide, much lower than a similar wt% of graphite. Example 25 shows that the surface resistivity can be reduced with a small concentration of additional graphite; similarly examples 29 and 33 show a reduction in surface resistivity due to additional carbon nanotubes. However, the largest reductions are seen when graphite, carbon black and carbon nanotubes are used together, either as a graphite rich combination as in examples 26 to 28, or a carbon black rich combination as in examples 30 to 32. The low surface resistivities reached are similar to those in examples 9 to 11, but for a reduced total pigment loading which increases coating durability. The lower carbon nanotube concentration of examples 26 to 28 also leads to a reduced viscosity compared to examples 15 to 19, which may be preferable.

**Table 2: The electrical sheet resistivity of conductive layers having different chemical compositions selected from carbon nanotubes, polyimide, graphite, carbon black, BYK 341 and BYK ES 80.**

| Example | MWCNT (wt%) | Carbon black (wt%) | Graphite (wt%) | Polyimide (wt%) | BYK 341 (wt%) residual | BYK ES 80 (wt%) residual | Thickness (µm) | Resistance (Ω/sq) |
|---|---|---|---|---|---|---|---|---|
| 24 | 0 | 40 | 0 | 60 | 0 | 0 | 16 | 100 |
| 25 | 0 | 40 | 10 | 50 | 0 | 0 | 12 | 39 |
| 26 | 4 | 10 | 50 | 36 | 0 | 0 | 14 | 15 |
| 27 | 4 | 20 | 40 | 36 | 0 | 0 | 16 | 14 |
| 28 | 4 | 30 | 30 | 36 | 0.02 | 0.02 | 18 | 15 |
| 29 | 4 | 40 | 0 | 56 | 0.03 | 0 | 10 | 53 |
| 30 | 4 | 40 | 10 | 46 | 0 | 0 | 15 | 28 |
| 31 | 4 | 40 | 15 | 41 | 0 | 0 | 16 | 22 |
| 32 | 4 | 40 | 20 | 36 1 | 0 | 0 | 14 | 25 |
| 33 | 4 | 50 | 0 | 46 | 0 | 0 | 14 | 48 |

## Claims

1. A conductive layer for use in a photovoltaic device or other electronic application, which comprises carbon nanotubes as a conductive material and carbon black and/or graphite as a conductive additive and a polymeric material, wherein the polymeric material is resistant to temperatures in the range of 200 to 600°C and the conductive layer has an electrical sheet resistance of less than 100 Ohm/square.

2. A conductive layer according to claim 1 wherein the photovoltaic device is a dye sensitised solar cell (DSSC).

3. A conductive layer according to claim 1 or 2 wherein the conductive layer is a back contact.

4. A conductive layer according to any one of the preceding claims wherein the polymeric material is resistant to temperatures in the range of 200 to 550°C.

5. A conductive layer according to any one of the preceding claims wherein the electrical sheet resistance of the conductive layer is 30 Ohm/square or less and preferably less than 15 Ohm/square.

6. A conductive layer according to any one of the preceding claims comprising 1% to 10% and preferably 3% to 8% by dry weight of the conductive material.

7. A conductive layer according to any one of the preceding claims wherein the polymeric material is a polyimide or a polysilane or a polysilicone.

8. A conductive layer according to any one of the preceding claims comprising 20% to 75%, preferably, 30% to 60% and more preferably 30% to 50% by dry weight of the polymeric material.

9. A conductive layer according to any one of the preceding claims comprising 20% to 80%, preferably, 30% to 60% and more preferably 40% to 60% by dry weight of the conductive additive or blends thereof.

10. A conductive layer according to any one of the preceding claims comprising a second additive, which comprises polyether modified polydimethylsiloxanes or salts of carboxylic esters or salts of unsaturated acidic carboxylic esters or siloxanes.

11. A method of producing the conductive layer according to any one of claims 1-10 for use in a photovoltaic device or other electronic application comprising the steps of:
i. placing carbon nanotubes as a conductive material, carbon black and/or graphite as a conductive additive, optionally a second additive and an organic solvent into a reaction vessel;
ii. mixing the conductive material, the conductive additive, optionally the second additive and the organic solvent together into a homogeneous dispersion;
iii. adding a polymeric material to the homogeneous dispersion to form a mixture;
iv. mixing the mixture and applying the mixture on a substrate;
v. drying and curing the polymeric material.

12. A method of providing the conductive layer produced according to claim 11 on a substrate, wherein the conductive layer is provided in a continuous reel to reel production line.

13. A dye sensitised solar cell comprising a metal carrier substrate, an electrically insulating layer on the metal carrier substrate, the conductive layer according to any one of claims 1 to 10, a photoabsorber layer comprising a dye sensitised metal oxide, a counter electrode on the photoabsorber layer and an encapsulated electrolyte between the photoabsorber layer and the counter electrode, preferably the dye sensitised solar cell comprises a second conductive layer between the insulating layer and the conductive layer

## Patentansprüche

1. Leitschicht zur Verwendung in einer photovoltaischen Vorrichtung oder ein anderen elektronischen Anwendung, die Kohlenstoffnanoröhren als Leitmaterial umfasst und Kohlenschwarz und/oder Graphit als leitfähigen Zusatzstoff und einen Polymerwerkstoff, wobei der Polymerwerkstoff im Bereich von 200 bis 600°C temperaturbeständig ist und die Leitschicht einen elektrischen Oberflächenwiderstand von weniger als 100 Ohm/Quadrat hat.

2. Leitschicht nach Anspruch 1, wobei die photovoltaische Vorrichtung eine farbstoffsensibilisierte Solarzelle (DSSC) ist.

3. Leitschicht nach Anspruch 1 oder 2, wobei die Leitschicht ein Rückkontakt ist.

4. Leitschicht nach einem der vorhergehenden Ansprüche, wobei der Polymerwerkstoff im Bereich von 200° bis 550°C temperaturbeständig ist.

5. Leitschicht nach einem der vorhergehenden Ansprüche, wobei der elektrische Flächenwiderstand der Leitschicht 30 Ohm/Quadrat oder weniger und vorzugsweise weniger als 5 Ohm/Quadrat ist.

6. Leitschicht nach einem der vorhergehenden Ansprüche, umfassend 1% bis 10% und vorzugsweise 3% bis 8% des Trockengewichts des Leitmaterials.

7. Leitschicht nach einem der vorhergehenden Ansprüche, wobei der Polymerwerkstoff ein Polyimid oder ein Polysilan oder ein Polysilikon ist.

8. Leitschicht nach einem der vorhergehenden Ansprüche, umfassend 20% bis 75%, vorzugsweise 30% bis 60% und besonders bevorzugt 30% bis 50% des Trockengewichts des Polymermaterials.

9. Leitschicht nach einem der vorhergehenden Ansprüche, umfassend 20% bis 80%, vorzugsweise 30% bis 60% und besonders bevorzugt 40% bis 60% des Trockengewichts des leitfähigen Zusatzstoffes oder Mischungen davon.

10. Leitschicht nach einem der vorhergehenden Ansprüche, umfassend einen zweiten Zusatzstoff, der Polyether-modifizierte Polydimethylsiloxane oder Salze von Carbonsäureestern oder Salze von ungesättigten sauren Carbonsäureestern oder Siloxane umfasst.

11. Verfahren zur Herstellung der Leitschicht nach einem der Ansprüche 1-10 zur Verwendung in einer photovoltaischen Vorrichtung oder einer anderen elektronischen Anwendung, umfassend die folgenden Schritte:
I Einbringen von Kohlenstoffnanoröhren als Leitmaterial, Kohlenschwarz und/oder Graphit als leitfähigen Zusatzstoff, gegebenenfalls einen zweiten Zusatzstoff und ein organisches Lösungsmittel in ein Reaktionsgefäß;
II. Mischen des Leitmaterials, des leitfähigen Zusatzstoffes, gegebenenfalls des zweiten Zusatzstoffes und des organische Lösungsmittels zusammen in einer homogenen Dispersion;
III. Hinzufügen eines Polymerwerkstoffs zu der homogenen Dispersion, um eine Mischung zu bilden;
IV. Mischen der Mischung und Aufbringen der Mischung auf ein Substrat;
V Trocknen und Härten des Polymerwerkstoffs.

12. Verfahren zur Bereitstellung der nach Anspruch 11 hergestellten Leitschicht auf einem Substrat, wobei die Leitschicht in einer kontinuierlichen Rolle zu Rolle Fertigungslinie vorgesehen ist.

13. Farbstoffsensibilisierte Solarzelle, umfassend ein Metallträgersubstrat, eine elektrisch isolierende Schicht auf dem Metallträgersubstrat, wobei die Leitschicht nach einem der Ansprüche 1 bis 10 vorliegt, eine Photoabsorptionsschicht mit einem farbstoffsensibilisierten Metalloxid, eine Gegenelektrode auf der Photoabsorptionsschicht und einen eingekapselten Elektrolyten zwischen der Photoabsorptionsschicht und der Gegenelektrode, vorzugsweise umfasst die farbstoffsensibilisierte Solarzelle eine zweite Leitschicht zwischen der Isolierschicht und der Leitschicht.

## Revendications

1. Couche conductrice à utiliser dans un dispositif photovoltaïque ou une autre application électronique, qui comprend des nanotubes de carbone en guise de matériau conducteur et du noir de carbone et/ou du graphite en guise d'additif conducteur et un matériau polymère, dans laquelle le matériau polymère est résistant à des températures dans la gamme de 200 à 600° C et la couche conductrice a une résistance de tôle magnétique de moins de 100 Ohms au carré.

2. Couche conductrice selon la revendication 1, dans laquelle le dispositif photovoltaïque est une cellule solaire à pigment photosensible (DSSC).

3. Couche conductrice selon la revendication 1 ou la revendication 2, dans laquelle la couche conductrice est un contact à ouverture.

4. Couche conductrice selon l'une quelconque des revendications précédentes, dans laquelle le matériau polymère est résistant à des températures dans la gamme de 200 à 550° C.

5. Couche conductrice selon l'une quelconque des revendications précédentes, dans laquelle la résistance de tôle magnétique de la couche conductrice est de 30 Ohms au carré ou moins et de préférence de moins de 15 Ohms au carré.

6. Couche conductrice selon l'une quelconque des revendications précédentes, comprenant de 1 % à 10 % et de préférence de 3 % à 8 % en poids sec du matériau conducteur.

7. Couche conductrice selon l'une quelconque des revendications précédentes, dans laquelle le matériau polymère est un polyimide ou un polysilane ou une polysilicone.

8. Couche conductrice selon l'une quelconque des revendications précédentes, comprenant de 20 % à 75 %, de préférence, de 30 % à 60 % et plus préférablement de 30 % à 50 % en poids sec du matériau polymère.

9. Couche conductrice selon l'une quelconque des revendications précédentes, comprenant de 20 % à 80 %, de préférence, de 30 % à 60 % et plus préférablement de 40 % à 60 % en poids sec de l'additif conducteur ou de mélanges de ceux-ci.

10. Couche conductrice selon l'une quelconque des revendications précédentes, comprenant un deuxième additif, qui comprend des polydiméthylsiloxanes modifiées par du polyéther ou des sels d'esters carboxyliques ou des sels d'esters carboxyliques acides insaturés ou des siloxanes.

11. Procédé de production de la couche conductrice selon l'une quelconque des revendications 1 à 10 à utiliser dans un dispositif photovoltaïque ou d'autre application électronique comprenant les étapes consistant à :
i. placer des nanotubes de carbone en guise de matériau conducteur, du noir de carbone et/ou du graphite en guise d'additif conducteur, éventuellement un deuxième additif et un solvant organique dans un vase de réaction ;
ii. mélanger le matériau conducteur, l'additif conducteur, éventuellement le deuxième additif et le solvant organique ensemble en une dispersion homogène ;
iii. ajouter un matériau polymère à la dispersion homogène pour former un mélange ;
iv. mélanger le mélange et appliquer le mélange sur un substrat ;
v. sécher et durcir le matériau polymère.

12. Procédé de fourniture d'une couche conductrice produite selon la revendication 11 sur un substrat, dans lequel la couche conductrice est fournie dans une ligne de production continue de bobine à bobine.

13. Cellule solaire à pigment photosensible comprenant un substrat porteur en métal, une couche électriquement isolante sur le substrat porteur en métal, la couche conductrice selon l'une quelconque des revendications 1 à 10, une couche de photoabsorbeur comprenant un oxyde de métal à pigment photosensible, une contre-électrode sur la couche de photoabsorbeur et un électrolyte encapsulé entre la couche de photoabsorbeur et la contre-électrode, de préférence la cellule solaire à pigment photosensible comprend une deuxième couche conductrice entre la couche isolante et la couche conductrice.
